(19) Europäisches Patentamt / European Patent Office / Office européen des brevets

(11) **EP 3 363 051 B1**

(12) **EUROPEAN PATENT SPECIFICATION**

(45) Date of publication and mention
of the grant of the patent:
**17.07.2019 Bulletin 2019/29**

(21) Application number: **17714812.9**

(22) Date of filing: **04.04.2017**

(51) Int Cl.:
*H01L 29/78* *(2006.01)*    *H01L 21/336* *(2006.01)*

(86) International application number:
**PCT/EP2017/058028**

(87) International publication number:
**WO 2017/174603 (12.10.2017 Gazette 2017/41)**

(54) **SHORT CHANNEL TRENCH POWER MOSFET**

GRABEN-LEISTUNGSMOSFET MIT KURZEM KANAL

MOSFET DE PUISSANCE À TRANCHÉE À CANAL COURT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.04.2016 EP 16164303**

(43) Date of publication of application:
**22.08.2018 Bulletin 2018/34**

(73) Proprietor: **ABB Schweiz AG
5400 Baden (CH)**

(72) Inventors:
• **MINAMISAWA, Renato
5210 Windisch (CH)**

• **KNOLL, Lars
5607 Hägglingen (CH)**

(74) Representative: **ABB Patent Attorneys
c/o ABB Schweiz AG
Intellectual Property CH-IP
Brown Boveri Strasse 6
5400 Baden (CH)**

(56) References cited:
JP-A- 2013 219 161    US-A- 6 051 482
US-A1- 2003 003 637    US-A1- 2014 110 723
US-A1- 2014 159 053    US-A1- 2014 306 284

Printed by Jouve, 75001 PARIS (FR)

**Description**

Field of the invention

The present invention relates to a short channel trench power MOSFET, and to a method for manufacturing the same.

Background of the invention

From US 2014/0159053 A1 there is known a silicon carbide trench gate transistor comprising an n-type drain region, an n-type drift region formed on the n-type drain region, a p-type base region formed on the n-type drift region, an n-type source region formed on the p-type base region, a gate trench and an n-type embedded channel region located under the source region and in the base region on the sidewall of the gate trench. The embedded channel region is described to have a thickness of 30 to 80 nm.

Document JP 2013219161 A discloses a power trench MOS device comprising a source layer of the first conductivity type and a body layer of opposite conductivity type as well as a channel layer of the first conductivity type extending directly on the gate insulation layer between the source layer and the substrate layer. The channel layer is disclosed as having a thickness between 30 and 80 nm.

From US 2014/0110723 A1 there is known a semiconductor device that includes: a semiconductor substrate; a first silicon carbide semiconductor layer located on a principal surface of the semiconductor substrate, the first silicon carbide semiconductor layer including a drift region of a first conductivity type, a body region of a second conductivity type, and an impurity region of a first conductivity type; a trench provided in the first silicon carbide semiconductor layer so as to reach inside of the drift region; a second silicon carbide semiconductor layer of the first conductivity type located at least on a side surface of the trench so as to be in contact with the impurity region and the drift region; a gate insulating film; a gate electrode; a first ohmic electrode; and a second ohmic electrode. The body region includes a first body region which is in contact with the second silicon carbide semiconductor layer on the side surface of the trench, and a second body region which is in contact with the drift region and has a smaller average impurity concentration than the first body region. A thickness of the second silicon carbide semiconductor layer in a range from 20 nm to 70 nm is disclosed.

Among different structures of power metal oxide semiconductor field effect transistor (MOSFET) devices, trench power MOSFETs have the advantage that the on-state resistance is relatively low. In a trench power MOSFET a current is conducted vertically from a source electrode on a first main side (i.e. a first main side surface) of the wafer to a drain electrode on a second main side (i.e. a second main side surface) of the wafer opposite to the first main side. To achieve a high drive capability a plurality of trenches penetrate through a p-doped body region below the first main side of the wafer. Inside of each trench there is formed a gate dielectric and a gate electrode to control the current conduction from an n-doped source region through a channel region in the p-doped body region adjacent to the trenches to an n--doped drift region by the field effect. Each trench corresponds to a MOSFET cell. All the MOSFET cells are connected between the source electrode and the drain electrode in parallel in order to reduce the on-state resistance. The n--doped drift region between the channel regions of the plurality of MOSFET cells and an $n^+$-doped drain layer in contact with the drain electrode allows a large voltage in off-state condition. In the on-state condition, the charge carriers drift through the n--drift region towards the $n^+$-doped drain layer due to the potential difference across it.

The power semiconductor industry is strongly moving toward scaling, which requires the improvement of the device electrostatics. Reducing the channel length in the known trench power MOSFET can strongly reduce on-state losses, however, at the cost of a shift of the threshold voltage $V_{th}$ and at the cost of early breakdown in reverse blocking.

For a high reverse blocking capability it is crucial to design the p-doped body region in a way to avoid leakage current under depletion to the $n^+$-doped source region. In a common trench power MOSFET the p-doped body region is implemented as a semiconductor layer having a typical thickness of about 1 $\mu$m and a moderate doping concentration of about $10^{17}$ cm$^{-3}$. Reducing the layer thickness of the p-doped body region and thus reducing the channel length would inevitably require higher doping, which in turn, would degrade the channel mobility due to coulombic scattering and significant shift of $V_{th}$ towards positive polarity.

From prior art document US 8 476 697 B1 there is known a silicon carbide (SiC) power double-diffused metal oxide semiconductor field effect transistor (DMOSFET) having a channel length of about 0.5 $\mu$m. A p-doped body region has a peak concentration of about $1 \cdot 10^{18}$ cm$^{-3}$ to $3 \cdot 10^{18}$ cm$^{-3}$ in order to avoid punch-through. The doping profile of the p-doped body region is a retrograde doping profile with p-type doping concentration of about $2.5 \cdot 10^{17}$ cm$^{-3}$ or greater in a channel region and about $1 \cdot 10^{18}$ cm$^{-3}$ to $3 \cdot 10^{18}$ cm$^{-3}$ near the p-n junction between the p-doped body region and the n--doped drift region. In order to avoid high oxide fields at threshold the channel region is counter-doped with an n-type dopant with a doping concentration of about $3 \cdot 10^{17}$ cm$^{-3}$ to $8 \cdot 10^{17}$ cm$^{-3}$, whereby, after compensation, the surface is n-type with a net doping concentration of about $1 \cdot 10^{17}$ cm$^{-3}$ to $3 \cdot 10^{17}$ cm$^{-3}$ up to a counter doping depth of 60 nm. There is also described a silicon carbide UMOSFET device, wherein a surface n-type layer is obtained by angled ion implantation into the trench sidewalls following trench etch. However, the power MOSFETs disclosed in US 8 476 697 B1 suffer from short-channel effects and a high subthreshold slope.

Summary of the invention

It is an object of the invention to provide a power semiconductor device having a low on-state resistance while avoiding any short channel effects and having a low subthreshold slope.

The object of the invention is attained by a power semiconductor device according to claim 1. The power semiconductor device according to the invention is a trench power field effect transistor, which comprises a compensation layer of a first conductivity type, wherein the compensation layer is extending on a gate insulation layer between a source layer and a substrate layer directly adjacent to a channel region, and wherein:

$$L_{ch} > 4\sqrt{\left(\frac{(\varepsilon_{CR} t_{COMP} t_{GI})}{\varepsilon_{GI}}\right)}, \qquad (1)$$

In the above inequation (1) $L_{ch}$ is a channel length, $\varepsilon_{CR}$ is a permittivity of the channel region, $\varepsilon_{GI}$ is a permittivity of the gate insulation layer, $t_{COMP}$ is a thickness of the compensation layer in a direction perpendicular to the interface between the gate insulation layer and the compensation layer, and $t_{GI}$ is a thickness of the gate insulation layer. Therein, the channel length is defined as the length of a shortest path along the gate insulation layer from the source layer to the substrate layer. Due to the compensation layer having the same conductivity type as the source layer, it might be difficult to decide at what depth (i.e. at what distance from the first main side surface of the wafer) the source layer ends and the compensation layer begins. For the purpose of determining the channel length, the depth, at which the source layer ends and the compensation layer begins, is therefore assumed to be the depth of the p-n junction between the source layer and the body layer at a lateral distance of 0.1 $\mu$m from the gate insulation layer. Likewise, for the purpose of determining the channel length, the depth, at which the compensation layer ends and the substrate layer begins is assumed to be the depth of the p-n junction between the body layer and the substrate layer at a lateral distance of 0.1 $\mu$m from the gate insulation layer. Throughout the specifications the term lateral refers to a direction parallel to the first main side of the wafer.

By satisfying inequation (1) the compensation layer can avoid short channel effects in a trench power field effect transistor device with a low subthreshold slope and an optimum threshold voltage even for a short channel length where prior art trench power field effect transistors show significant short channel effects.

In the power semiconductor device of the invention a thickness of the compensation layer is in a range from 1 nm to 10 nm. The thickness is measured in a direction perpendicular to the gate insulation layer. The lower limit of 1 nm ensures efficient reduction of the threshold voltage $V_{th}$ and increase of the channel carrier mobility, while the upper limit ensures that short channel effects can be reduced especially efficient.

Further developments of the invention are specified in the dependent claims.

In exemplary embodiments the thickness of the compensation layer is in a range from 2 nm to 5 nm.

In exemplary embodiments the channel length is less than 0.5 $\mu$m or less than 0.3 $\mu$m. Such short channel length results in a low on-state voltage, i.e. in low on-state losses.

In an exemplary embodiment a doping concentration in the compensation layer is at least $1\cdot10^{18}$cm$^{-3}$ or at least $5\cdot10^{18}$ cm$^{-3}$. Such high doping concentration of the compensation layer results in most efficient reduction of short channel effects and reduction of the threshold voltage by the compensation layer. Throughout this specification a doping concentration of a layer or region shall refer to a peak net doping concentration of the layer, i.e. to a maximum net doping concentration of this layer, unless it is referred to a doping profile. If it is referred to a doping profile then the term doping concentration shall refer to a local net doping concentration.

In an exemplary embodiment a doping concentration in the channel region is at least $5\cdot10^{17}$ cm$^{-3}$ or at least $1\cdot10^{18}$ cm$^{-3}$ or at least $5\cdot10^{18}$ cm$^{-3}$. Such high doping concentration in the channel region can efficiently avoid punch-through in the blocking state at high reverse voltages.

In an exemplary embodiment the substrate layer, the body layer, the compensation layer and the source layer are silicon carbide layers. Silicon carbide (SiC) has a breakdown strength which is about ten times higher than that of silicon (Si), resulting in much lower losses for SiC-based devices.

In an exemplary embodiment the power semiconductor device comprises a well region of the second conductivity type, wherein the well region is directly adjacent to the gate insulation layer below a bottom of the gate electrode. Such well region can efficiently protect the gate insulation layer against high electric fields.

The power semiconductor device of the invention may be manufactured by a method according to claim 11. Performing the step of deepening the trench by removing material of the second semiconductor layer and of the first semiconductor layer such that the deepened trench penetrates into the first semiconductor layer only after the step of applying an impurity of the first conductivity type into a sidewall of the at least one trench allows to apply the impurity of the first conductivity type only into the second semiconductor layer and the third semiconductor layer, while avoiding to apply the impurity of the first conductivity type into the first semiconductor layer.

In exemplary embodiments applying the impurity of the first conductivity type into the sidewall of the at least one trench is performed by angled ion implantation or by plasma immersion ion implantation (PIII). Plasma immersion ion implantation allows to form the compensation layer with a homogeneous doping concentration profile along a direction parallel to the sidewall of the trench, i.e. a doping concentration profile, which is nearly independent from the depth in the trench. Furthermore, by plasma immersion ion implantation only few defects are created, which further reduces the short channel effects.

Brief description of the drawings

Detailed embodiments of the invention will be explained below with reference to the accompanying figures, in which:

Fig. 1          shows a partial cross sectional view of a power semiconductor device according to an embodiment of the invention;
Fig. 2          shows an enlarged portion of the cross sectional view in Fig. 1; and
Figs. 3A to 3G   show partial cross sectional views illustrating different steps of a method for manufacturing the power semiconductor device of Fig. 1.

The reference signs used in the figures and their meanings are summarized in the list of reference signs. Generally, similar elements have the same reference signs throughout the specification. The described embodiments are meant as examples and shall not limit the scope of the invention.

Detailed Description of preferred embodiments

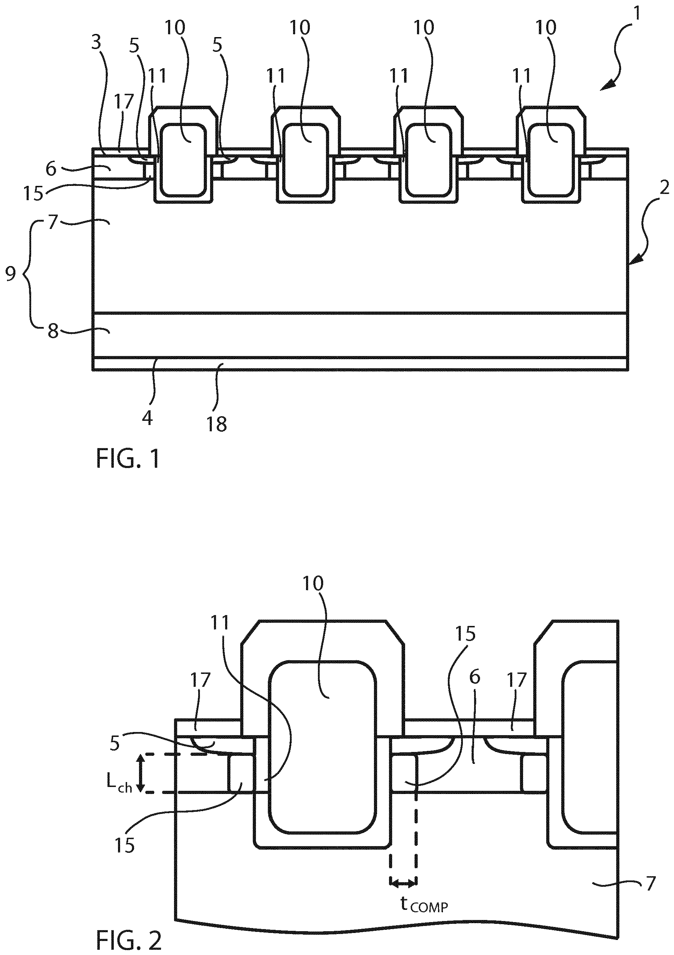

In Fig. 1 there is shown a cross sectional view of a power semiconductor device according to an embodiment of the invention. Fig. 2 shows an enlarged portion of Fig. 1. The power semiconductor device according to the embodiment of the invention is a trench power metal oxide semiconductor field effect transistor (MOSFET) 1. It comprises a silicon carbide (SiC) wafer 2 having a first main side 3 and a second main side 4. Throughout the specification the term silicon carbide may refer to any polytype of silicon carbide, in particular it may refer to 4H-SiC or 6H-SiC. In an order from the first main side 3 to the second main side 4, the SiC wafer 2 comprises an $n^+$-doped source layer 5, a p-doped body layer 6, an $n^-$-doped drift layer 7 and an $n^+$-doped drain layer 8. The drift layer 7 and the drain layer 8 form an n-doped substrate layer 9. The source layer 5 is separated from the drift layer 7 by the body layer 6, and the body layer 6 is separated from the drain layer 8 by the drift layer 7. A plurality of electrically conductive gate electrodes 10 penetrate through the body layer 6. Each gate electrode 10 is configured to control an electrical conductivity of a channel region in the body layer 6 by an electrical field when applying an electrical potential to the gate electrode 10. Therein, each channel region is a portion of the body layer 6, which extends from the source layer 5 to the drift layer 7. A MOS channel may be formed from the source layers 5 via the channel regions to the drift layer 7. A gate insulation layer 11 electrically insulates the gate electrode 10 from the drift layer 7, from the body layer 6 and from the source layer 5.

Directly adjacent to the channel region an n-doped compensation layer 15 extends on the gate insulation layer 11 between the source layer 5 and the drift layer 7. A thickness $t_{COMP}$ of the compensation layer 15 in a direction perpendicular to the interface between the gate insulation layer 11 and the compensation layer 15, a channel length $L_{ch}$, which is defined as the length of the shortest path from the source layer 5 to the drift layer 7 on the interface between the gate insulation layer 11 and the compensation layer 15, and a thickness $t_{GI}$ of the gate insulation layer 11 in a direction perpendicular to the interface between the gate insulation layer 11 and the compensation layer 15 fulfil the following inequation:

$$L_{ch} > 4\sqrt{\left(\frac{(\varepsilon_{CR} t_{COMP} t_{GI})}{\varepsilon_{GI}}\right)} \qquad (1),$$

wherein $\varepsilon_{CR}$ is a permittivity of the channel region and $\varepsilon_{GI}$ is a permittivity of the gate insulation layer 11. As indicated above, due to the compensation layer 15 having the same conductivity type as the source layer 5, it might be difficult to decide at what depth (i.e. at what distance from the first main side 3 of the SiC wafer 2) the source layer 5 ends and the compensation layer 15 begins. For the purpose of determining the channel length $L_{ch}$, the depth, at which the source layer 5 ends and the compensation layer 15 begins, is assumed to be the depth of the p-n junction between the source layer 5 and the body layer 6 at a lateral distance of 0.1 $\mu$m from the gate insulation layer 11. Likewise, for the purpose of determining the channel length $L_{ch}$, the depth, at which the compensation layer 15 ends and the drift layer 7 begins, is assumed to be the depth of the p-n junction between the body layer 6 and the drift layer 7 at a lateral distance of 0.1 $\mu$m from the gate insulation layer 11. The channel region is defined as a portion of the body layer 6, the electrical conductivity of which can be controlled by applying an electrical potential to the gate electrode 10. Exemplarily, the channel region is defined as a portion of the body layer which has a distance of less than 0.1 $\mu$m from the compensation layer 15.

The thickness $t_{COMP}$ of the compensation layer 15 is in a range from 1 nm to 10 nm, exemplarily in a range from 2 nm to 5 nm. The channel length $L_{ch}$ may be less than 0.5 $\mu$m, exemplarily less than 0.3 $\mu$m. In the power semiconductor device according to the present embodiment the interface between the gate insulation layer 11 and the compensation layer 15 is vertical to the first main side 3. In this case the channel length $L_{ch}$ corresponds to a distance between the source layer 5 and the drift layer 7 at a lateral distance of 0.1 $\mu$m from the gate insulation layer 11, which is the thickness of the body layer 6 in a direction perpendicular to the first main side 3 at a lateral distance of 0.1 $\mu$m from the gate insulation layer 11.

A doping concentration in the compensation layer 15 may be at least $1 \cdot 10^{18}$cm$^{-3}$, exemplarily at least $5 \cdot 10^{18}$ cm$^{-3}$. A doping concentration in the channel region may be at least $5 \cdot 10^{17}$ cm$^{-3}$, exemplarily at least $1 \cdot 10^{18}$ cm$^{-3}$, more exemplarily at least $5 \cdot 10^{18}$ cm$^{-3}$.

A thickness of the drift layer 7 depends on the nominal voltage, i.e. on the maximum blocking voltage in reverse direction, for which the device is designed. For example, a nominal blocking voltage of 1 kV requires a thickness of the drift layer 7 of about 6 $\mu$m and a nominal blocking voltage of 5 kV requires a thickness of the drift layer 7 of about 36 $\mu$m. The ideal doping concentration of the drift layer 7 depends also on the nominal voltage and is exemplarily in a range between $1 \cdot 10^{15}$cm$^{-3}$ and $5 \cdot 10^{16}$cm$^{-3}$. A thickness of the source layer 5 is exemplarily in a range between 0.5 $\mu$m and 5 $\mu$m, while a doping concentration of the source layer 5 is exemplarily $1 \cdot 10^{18}$ cm$^{-3}$ or more.

A source electrode 17 is arranged on the first main side 3 of the SiC wafer 2. It forms an ohmic contact to the source layer 5. To avoid triggering of a parasitic bipolar transistor formed by the body layer 6, the source layer 5 and the drift layer 7, the body layer 6 is also electrically connected to the source electrode 17. On the second main side 4 of the SiC wafer 2 a drain electrode 18 is arranged, which forms an ohmic contact to the drain layer 8.

Below each gate electrode 10 there is formed a p-doped well region 42 directly adjacent to the gate insulation layer 11 below a bottom of the gate electrode 10. The well region 42 is separated from the body layer 6 by the drift layer 7. The well region 42 can efficiently protect the gate insulation layer 11 against high electric fields.

In a plane parallel to and below the first main side 3, gate electrodes 10, may have a cross-section of any shape, exemplarily a longitudinal line shape, a honeycomb shape, a polygonal shape, a round shape or an oval shape.

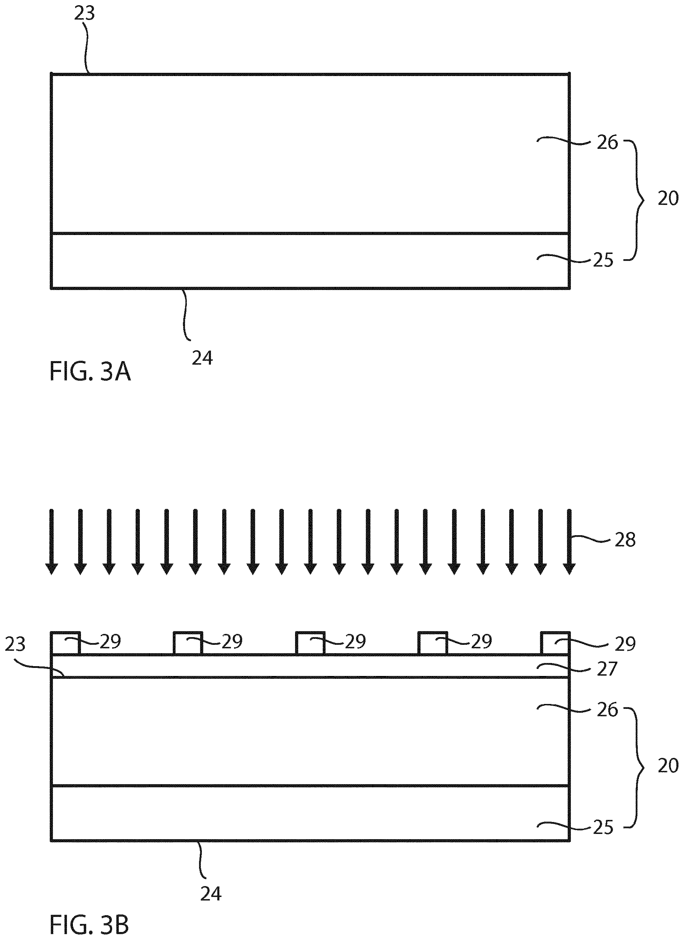

Referring to Figures 3A to 3G a method for manufacturing the power semiconductor device according to the embodiment of the invention shown in Figs. 1 and 2 is described in the following. In a first method step an n-doped first semiconductor layer 20 is provided as shown in Fig. 3A. The first semiconductor layer 20 has a first main side 23 and a second main side 24 opposite to the first main side 23. It includes an n$^{+}$-doped SiC layer 25, which forms the drain layer 8 in the final trench power MOSFET 1, and an n$^{-}$-doped SiC layer 26, which forms the drift layer 7 in the final trench power MOSFET 1. The n$^{+}$-doped SiC layer 25 may be a SiC substrate wafer on which the n$^{-}$-doped SiC layer 26 is deposited epitactically by chemical vapour deposition (CVD), for example. Alternatively, the n$^{-}$-doped SiC layer 26 may be a substrate wafer, on which the n$^{+}$-doped SiC layer 25 is deposited epitactically by CVD, for example, or in which the n$^{+}$-doped SiC layer 25 may be formed by applying a p-type dopant by ion implantation, for example.

Thereafter a p-doped second semiconductor layer 27 is formed on the first main side 23 of the first semiconductor layer 20 to be in direct contact with the first semiconductor layer 20 as shown in Fig. 3B. The second semiconductor layer 27 may be deposited epitactically onto the n$^{-}$-doped SiC layer 26 by CVD, for example, or it may be formed by applying an n-type dopant by ion implantation, for example, into the first semiconductor layer 20 from its first main side 23. Forming the second semiconductor layer 27 by ion implantation requires a subsequent activation of the implanted impurity by heat treatment. In the final trench power MOSFET 1 the second semiconductor layer 27 forms the p-doped body layer 6.

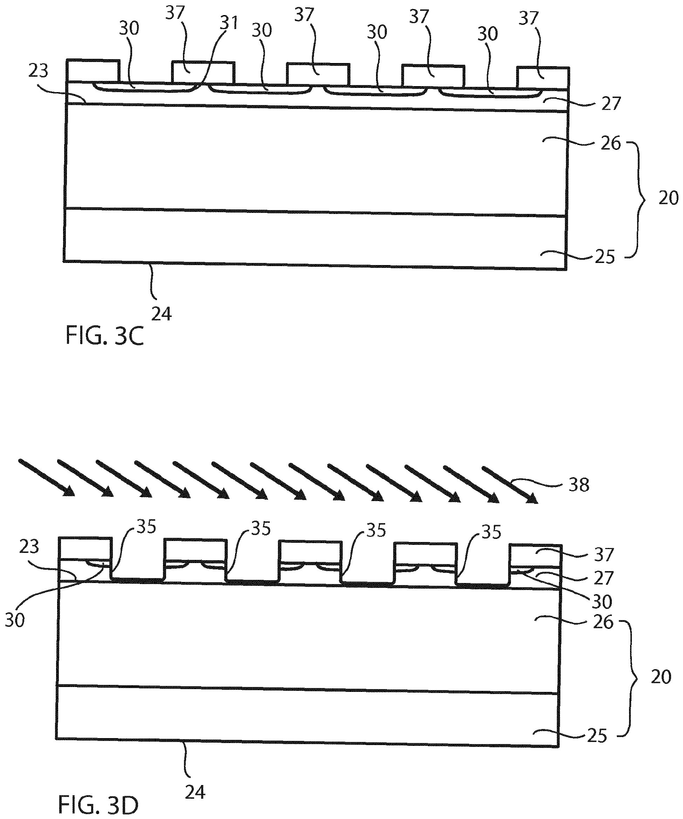

Thereafter an n$^{+}$-doped third semiconductor layer 30, which is in direct contact with the second semiconductor layer 27 and which is separated from the first semiconductor layer 20 by the second semiconductor layer 27, is formed as shown in Fig. 3C. Specifically, the third semiconductor layer 30 may be formed by applying a first n-type impurity 28 into the second semiconductor layer 27 by ion implantation, for example, using an implantation mask 29 as illustrated in Fig. 3B. Forming the third semiconductor layer 30 by ion implantation requires a subsequent activation of the implanted impurity by heat treatment. The third semiconductor layer 30 has openings 31 as shown in Fig. 3C through which the second semiconductor layer 27 is exposed for forming an electrical contact to the source electrode 17 at a later stage (see Fig. 1). In the final trench power MOSFET 1 the third semiconductor layer 30 forms the source layer 5.

In a next method step a plurality of trenches 35 is formed in the stack of the first to third semiconductor layer 20, 27 and 30 such that the trench 35 penetrates through the third semiconductor layer 30 into the second semiconductor layer 27 by removing material of the second semiconductor layer 27 and of the third semiconductor layer 30. Removing material of the second semiconductor layer 27 and of the third semiconductor layer 30 can exemplarily be done by selective etching of the second semiconductor layer 27 and of the third semiconductor layer 30 using an etching mask 37 as shown in Figs. 3C and 3D. The trench 35 has a depth at or close to the interface between the first semiconductor layer 20 and the second semiconductor layer 27.

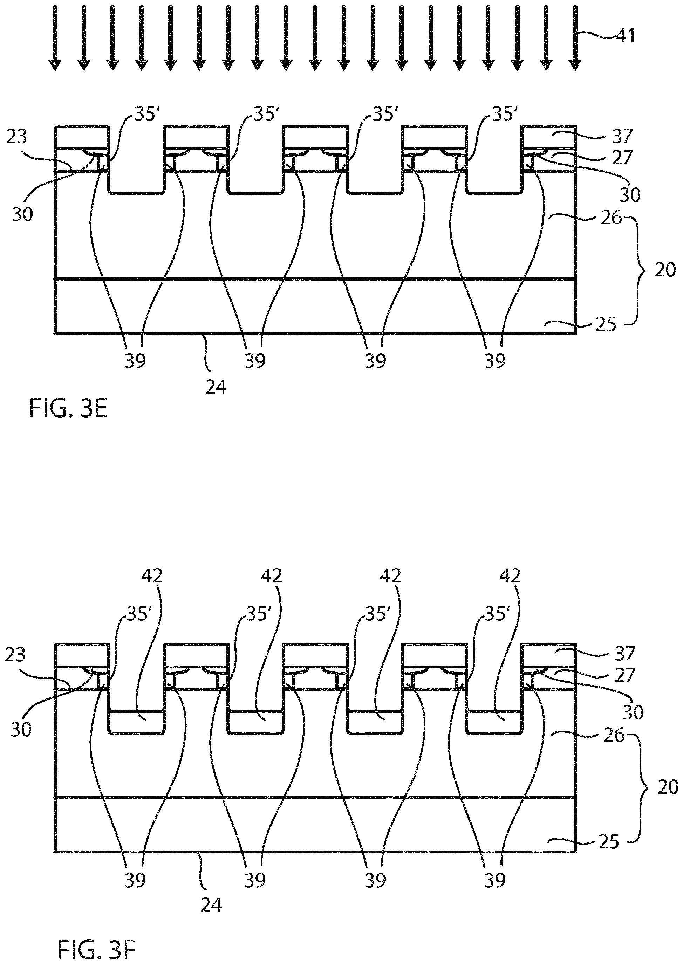

After forming the trenches 35, a second n-type impurity 38 is applied into a sidewall of each trench 35 to form an n-doped semiconductor region 39, which extends from the third semiconductor layer 30 to the first semiconductor layer 20 as shown in Figs. 3D and 3E. The depth of the trench 35 has to be close enough to the interface between the first semiconductor layer 20 and the second semiconductor layer 27 to form the n-doped semiconductor region 39 to extend from the third semiconductor layer 30 to the first semiconductor layer 20. On the other side applying the second n-type impurities 38 into the first semiconductor layer 20 should be avoided or reduced to a minimum. To achieve the latter goal, the trench 30 should not extend into the first semiconductor layer 20. The second n-type impurity 38 may be applied into the sidewall of each trench 35 by angled ion implantation or by plasma immersion ion implantation. The inclined arrows in Fig. 3D refer to angled ion implantation. The arrows in Fig. 3D are directed only in one direction. However, when angled ion implantation is used, a plurality of different angels is used to achieve a homogeneous doping concentration profile along the sidewalls of trenches 35, respectively.

After the step of applying the second n-type impurity 38 into the sidewall of each trench 35 the trenches 35 are deepened by removing material of the second semiconductor layer 27 and of the first semiconductor layer 20 such that the deepened trenches 35' penetrate into the first semiconductor layer 20, respectively, as shown in Fig. 3F. Removing material of the second semiconductor layer 27 and of the first semiconductor layer 20 may be performed by an etching step using etching mask 37 A p-doped semiconductor well region 42 may be formed below a bottom of each deepened trench 35' by applying a p-type impurity 41 into the first semiconductor layer 20 through the bottom of each deepened trench 35' as shown in Figs. 3E and 3F.

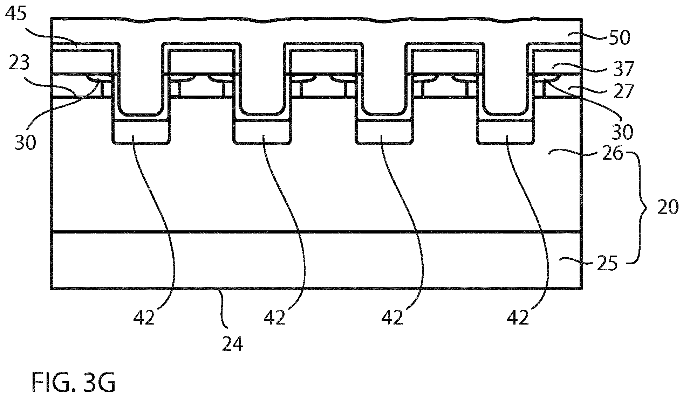

In a next method step an insulation layer 45 is formed to cover the sidewall and the bottom of each deepened trench 35' and thereafter an electrode layer 50 is formed in the deepened trench 35' on the insulation layer 45 as shown in Fig. 3G. Therein, the electrode layer 50 is electrically insulated from the first semiconductor layer 20, the second semiconductor layer 27, the third semiconductor layer 30 and the n-doped semiconductor region 39 by the insulation layer 45. Before forming the insulation layer 45 the etching mask 37 is removed by selective etching, for example. The electrode layer 50 may be a polysilicon layer, for example, and the insulation layer may be a silicon oxide layer, for example. In the final trench power MOSFET 1 shown in Figs. 1 and 2 the electrode layer 50 forms the gate electrodes 10 and the insulation layer 45 forms the gate insulation layer 11.

Next, the electrode layer 50 is structured (i.e. any material of the electrode layer 50 which is no material of the gate electrodes 10 in the final device 1 is removed) and covered by an additional insulation layer, the source electrode 17 is formed on the third semiconductor layer 30 and the drain electrode 18 is formed on the second main side 24 of the first semiconductor layer 20 to obtain the final trench power MOSFET 1 as shown in Figs. 1 and 2.

In the description above, a specific embodiment was described. However, alternatives and modifications of the above described embodiment are possible.

In the above described method for manufacturing the power semiconductor device shown in Fig. 1 the third semiconductor layer 30 is formed by applying the first n-type impurity 28 into the second semiconductor layer 27 by ion implantation, for example, using the implantation mask 29 as illustrated in Fig. 3B. However, it is also possible to form the third semiconductor layer 30 by other methods, such as epitactically on the second semiconductor layer 27 by CDV, for example.

In the above described embodiment of the invention the trench power MOSFET 1 comprises the p-doped well region 42 for protecting the gate insulation layer 11 against high electric fields. However, in a modified embodiment the trench power MOSFET 1 does not include the p-doped well region 42.

In the above description a trench power MOSFET 1 was described as an embodiment of the power semiconductor device of the invention. However, the invention is not limited to a trench power MOSFET. For example, another embodiment of the power semiconductor device of the invention is a trench insulated gate bipolar transistor (IGBT). Such trench IGBT differs from the trench power MOSFET 1 described above in an additional p-doped layer on the second main side 4 of the SiC wafer 2.

The above embodiments were explained with specific conductivity types. The conductivity types of the semiconductor layers in the above described embodiments might be switched, so that in a specific embodiment all layers which were described as p-type layers would be n-type layers and all layers which were described as n-type layers would be p-type layers. For example, in a modified embodiment, the source layer 5 may be a p-doped layer, the body layer 6 may be an n-doped layer, and the substrate layer 9 may be a p-doped layer.

It should be noted that the term "comprising" does not exclude other elements or steps and that the indefinite article "a" or "an" does not exclude the plural. Also elements described in association with different embodiments may be combined.

List of reference signs

| | |
|---|---|
| 1 | trench power metal oxide semiconductor field effect transistor (MOSFET) |
| 2 | silicon carbide (SiC) wafer |
| 3, 23 | first main side |
| 4, 24 | second main side |
| 5 | (n$^+$-doped) source layer |
| 6 | (p-doped) body layer |
| 7 | (n$^-$-doped) drift layer |
| 8 | (n$^+$-doped) drain layer |
| 9 | (n-doped) substrate layer |
| 10 | gate electrode |
| 11 | gate insulation layer |
| 15 | (n-doped) compensation layer |
| 17 | source electrode |
| 18 | drain electrode |
| 20 | (n-doped) first semiconductor layer |
| 23 | first main side |
| 24 | second main side |
| 25 | n$^+$-doped SiC layer |
| 26 | n$^-$-doped SiC layer, |
| 27 | (p-doped) second semiconductor layer |
| 28 | first n-type impurity |
| 29 | implantation mask |
| 30 | (n$^+$-doped) third semiconductor layer |
| 31 | opening |
| 35 | trench |
| 35' | deepened trench |
| 37 | etching mask |
| 38 | second n-type impurity |
| 39 | n-doped semiconductor region |
| 42 | p-doped well region |
| 45 | insulation layer |
| 50 | electrode layer |
| $L_{ch}$ | channel length |
| $t_{COMP}$ | thickness of the compensation layer 15 |

**Claims**

1.  A power semiconductor device (1) comprising:

    a substrate layer (9) having a first conductivity type;
    a body layer (6) provided on the substrate layer (9) and having a second conductivity type, which is different from the first conductivity type;
    a source layer (5) provided on the body layer (6) and having the first conductivity type, wherein the body layer (6) comprises a channel region extending from the source layer (5) to the substrate layer (9),
    an electrically conductive gate electrode (10) penetrating through the body layer (6) for controlling electrical conductivity of the channel region,
    a gate insulation layer (11) electrically insulating the gate electrode (10) from the substrate layer (9), from the body layer (6) and from the source layer (5),
    a compensation layer (15) of the first conductivity type, which is extending directly on the gate insulation layer (11) between the source layer (5) and the substrate layer (9) directly adjacent to the channel region, the channel region being defined as a portion of the body layer (6) which has a distance of less than 0.1 $\mu$m from the compensation layer (15), wherein:

7

$$L_{ch} > 4\sqrt{\left(\frac{(\varepsilon_{CR} t_{COMP} t_{GI})}{\varepsilon_{GI}}\right)},$$

wherein $L_{ch}$ is a channel length, $\varepsilon_{CR}$ is a permittivity of the channel region, $\varepsilon_{GI}$ is a permittivity of the gate insulation layer (11), $t_{COMP}$ is a thickness of the compensation layer (15) in a direction perpendicular to an interface between the gate insulation layer (11) and the compensation layer (15), and $t_{GI}$ is a thickness of the gate insulation layer (11),

**characterized in that** the thickness $t_{COMP}$ of the compensation layer (15) is in a range from 1 nm to 10 nm.

2. The power semiconductor device according to claim 1, wherein the thickness $t_{COMP}$ of the compensation layer (15) is in a range from 2 nm to 5 nm.

3. The power semiconductor device according to claim 1 or 2, wherein the channel length $L_{ch}$ is less than 0.5 $\mu$m.

4. The power semiconductor device according to claim 1 or 2, wherein the channel length $L_{ch}$ is less than 0.3 $\mu$m.

5. The power semiconductor device according to anyone of claims 1 to 4, wherein a doping concentration in the compensation layer (15) is at least $1 \cdot 10^{18}$ cm$^{-3}$.

6. The power semiconductor device according to claim 5, wherein a doping concentration in the compensation layer (15) is at least $5 \cdot 10^{18}$ cm$^{-3}$.

7. The power semiconductor device according to anyone of claims 1 to 6, wherein a doping concentration in the channel region is at least $5 \cdot 10^{17}$ cm$^{-3}$.

8. The power semiconductor device according to anyone of claims 1 to 6, wherein a doping concentration in the channel region is at least $1 \cdot 10^{18}$ cm$^{-3}$ or at least $5 \cdot 10^{18}$ cm$^{-3}$.

9. The power semiconductor device according to anyone of claims 1 to 8, wherein the substrate layer (9), the body layer (6), the compensation layer (15) and the source layer (5) are silicon carbide layers.

10. The power semiconductor device according to anyone of claims 1 to 9, comprising a well region (42) of the second conductivity type, wherein the well region (42) is directly adjacent to the gate insulation layer (11) below a bottom of the gate electrode (10).

11. A method for manufacturing a power semiconductor device (1) according to anyone of claims 1 to 10, the method comprising the following steps:

providing a first semiconductor layer (20) of the first conductivity type, wherein the first semiconductor layer (20) has a first main side (23) and a second main side (24) opposite to the first main side (23), wherein the first semiconductor layer (20) forms the substrate layer (9) in the power semiconductor device (1);
forming a second semiconductor layer (27) of the second conductivity type on the first main side (23) of the first semiconductor layer (20) to be in direct contact with the first semiconductor layer (20), wherein the second semiconductor layer (27) forms the body layer (6) in the power semiconductor device (1);
forming a third semiconductor layer (30) of the first conductivity type, which is in direct contact with the second semiconductor layer (27) and which is separated from the first semiconductor layer (20) by the second semiconductor layer (27), wherein the third semiconductor layer (30) forms the source layer (5) in the power semiconductor device (1);
forming at least one trench (35) penetrating through the third semiconductor layer (30) into the second semiconductor layer (27) by removing material of the third and second semiconductor layer (30, 27);
applying an impurity (38) of the first conductivity type into a sidewall of the at least one trench (35) to form a semiconductor region (38) of the first conductivity type, which connects the third semiconductor layer (30) with the first semiconductor layer (20), wherein the semiconductor region (38) forms the compensation layer (15) in the power semiconductor device (1);
deepening the trench (35) by removing material of the second and first semiconductor layer (20, 27) such that the deepened trench (35') penetrates into the first semiconductor layer (20);
forming an insulation layer (45) covering the sidewall and a bottom of the at least one deepened trench (35'), wherein the insulation layer (45) forms the gate insulation layer (11) in the power semiconductor device (1); and forming an electrode layer (50) in the at least one deepened trench (35'), the electrode layer (50) being electrically insulated from the first semiconductor layer (20), the second semiconductor layer (27), the third semiconductor layer (30) and the semiconductor region (38) of the first conductivity type by the insulation layer (45), wherein the electrode layer (50) forms the gate electrode (10) in the power semiconductor device (1).

12. The method for manufacturing a power semiconductor device according to claim 11, wherein applying the impurity (38) of the first conductivity type into the sidewall of the at least one trench (35) is performed by angled ion implantation.

13. The method for manufacturing a power semiconductor device according to claim 11, wherein applying the impurity (38) of the first conductivity type into the sidewall of the at least one trench (35) is performed by plasma immersion ion implantation.

14. The method for manufacturing a power semiconductor device according to anyone of claims 11 to 13, wherein a semiconductor well region (42) of the second conductivity type is formed below a bottom of the at least one deepened trench (35') by applying an impurity of the second conductivity type into the first semiconductor layer (20) through the bottom of the at least one deepened trench (35').

15. The method for manufacturing a power semiconductor device according to anyone of claims 11 to 14, wherein the third semiconductor layer (30) is formed by applying an impurity of the first conductivity type into the second semiconductor layer (27).

**Patentansprüche**

1. Leistungshalbleiterbauelement (1), umfassend:

eine Substratschicht (9) mit einem ersten Leitfähigkeitstyp;
eine Body-Schicht (6), die auf der Substratschicht (9) vorgesehen ist und einen zweiten Leitfähigkeitstyp aufweist, der vom ersten Leitfähigkeitstyp verschieden ist,
eine Source-Schicht (5), die auf der Body-Schicht (6) vorgesehen ist und den ersten Leitfähigkeitstyp aufweist, wobei die Body-Schicht (6) eine Kanalregion umfasst, die sich von der Source-Schicht (5) zur Substratschicht (9) erstreckt,
eine elektrisch leitende Gate-Elektrode (10), die durch die Body-Schicht (6) durchdringt, zum Steuern der elektrische Leitfähigkeit der Kanalregion,
eine Gate-Isolierschicht (11), welche die Gate-Elektrode (10) von der Substratschicht (9), der Body-Schicht (6) und der Source-Schicht (5) elektrisch isoliert,
eine Kompensationsschicht (15) des ersten Leitfähigkeitstyps, die sich direkt auf der Gate-Isolierschicht (11) zwischen der Source-Schicht (5) und der Substratschicht (9) direkt benachbart zur Kanalregion erstreckt, wobei die Kanalregion als ein Abschnitt der Body-Schicht (6) definiert ist, der einen Abstand von weniger als 0,1 $\mu$m von der Kompensationsschicht (15) aufweist, wobei:

$$L_{ch} > 4\sqrt{\left(\frac{(\varepsilon_{CR} t_{COMP} t_{GI})}{\varepsilon_{GI}}\right)},$$

wobei $L_{ch}$ eine Kanallänge ist, $\varepsilon_{CR}$ eine Dielektrizitätskonstante der Kanalregion ist, $\varepsilon_{GI}$ eine Dielektrizitätskonstante der Gate-Isolierschicht (11) ist, $t_{COMP}$ eine Dicke der Kompensationsschicht (15) in einer Richtung senkrecht auf eine Grenzfläche zwischen der Gate-Isolierschicht (11) und der Kompensationsschicht (15) ist, und $t_{GI}$ eine Dicke der Gate-Isolierschicht (11) ist,
**dadurch gekennzeichnet, dass** die Dicke $t_{COMP}$ der Kompensationsschicht (15) im Bereich von 1 nm bis 10 nm liegt.

2. Leistungshalbleiterbauelement nach Anspruch 1, **dadurch gekennzeichnet, dass** die Dicke $t_{COMP}$ der Kompensationsschicht (15) im Bereich von 2 nm bis 5 nm liegt.

3. Leistungshalbleiterbauelement nach Anspruch 1 oder 2, wobei die Kanallänge $L_{ch}$ weniger als 0,5 $\mu$m beträgt.

**4.** Leistungs-Halbleiterbauelement nach Anspruch 1 oder 2, wobei die Kanallänge $L_{ch}$ weniger als 0,3 $\mu$m beträgt.

**5.** Leistungshalbleiterbauelement nach einem der Ansprüche 1 bis 4, wobei eine Dotierungskonzentration in der Kompensationsschicht (15) mindestens $1 \cdot 10^{18}$ cm$^{-3}$ beträgt.

**6.** Leistungshalbleiterbauelement nach einem der Ansprüche 1 bis 5, wobei eine Dotierungskonzentration in der Kompensationsschicht (15) mindestens $5 \cdot 10^{18}$ cm$^{-3}$ beträgt.

**7.** Leistungshalbleiterbauelement nach einem der Ansprüche 1 bis 6, wobei eine Dotierungskonzentration in der Kanalregion mindestens $5 \cdot 10^{17}$ cm$^{-3}$ beträgt.

**8.** Leistungshalbleiterbauelement nach einem der Ansprüche 1 bis 6, wobei eine Dotierungskonzentration in der Kanalregion mindestens $1 \cdot 10^{18}$ cm$^{-3}$ oder mindestens $5 \cdot 10^{18}$ cm$^{-3}$ beträgt.

**9.** Leistungshalbleiterbauelement nach einem der Ansprüche 1 bis 8, wobei die Substratschicht (9), die Body-Schicht (6), die Kompensationsschicht (15) und die Source-Schicht (5) Siliciumcarbidschichten sind.

**10.** Leistungshalbleiterbauelement nach einem der Ansprüche 1 bis 9, umfassend eine Muldenregion (42) des zweiten Leitfähigkeitstyps, wobei die Muldenregion (42) direkt benachbart zur Gate-Isolierschicht (11) unter einer Unterseite der Gate-Elektrode (10) ist.

**11.** Verfahren zur Herstellung eines Leistungshalbleiterbauelements (1) nach einem der Ansprüche 1 bis 10, wobei das Verfahren die folgenden Schritte umfasst:

Bereitstellen einer ersten Halbleiterschicht (20) des ersten Leitfähigkeitstyps, wobei die erste Halbleiterschicht (20) eine erste Hauptseite (23) und eine zweite Hauptseite (24) gegenüber der ersten Hauptseite (23) aufweist, wobei die erste Halbleiterschicht (20) die Substratschicht (9) im Leistungshalbleiterbauelement (1) bildet;
derartiges Bilden einer zweiten Halbleiterschicht (27) des zweiten Leitfähigkeitstyps auf der ersten Hauptseite (23) der Halbleiterschicht (20), dass sie mit der ersten Halbleiterschicht (20) in direktem Kontakt ist, wobei die zweite Halbleiterschicht (27) die Body-Schicht (6) im Leistungshalbleiterbauelement (1) bildet;
Bilden einer dritten Halbleiterschicht (30) des ersten Leitfähigkeitstyps, die mit der zweiten Halbleiterschicht (27) in direktem Kontakt und von der ersten Halbleiterschicht (20) durch die zweite Halbleiterschicht (27) getrennt ist, wobei die dritte Halbleiterschicht (30) die Source-Schicht (5) im Leistungshalbleiterbauelement (1) bildet;
Bilden mindestens eines Grabens (35), der durch die dritte Halbleiterschicht (30) in die zweite Halbleiterschicht (27) eindringt, durch Entfernen von Material der dritten und der zweiten Halbleiterschicht (30, 27);
Einbringen einer Verunreinigung (38) des ersten Leitfähigkeitstyps in eine Seitenwand des mindestens einen Grabens (35), um eine Halbleiterregion (38) des ersten Leitfähigkeitstyps zu bilden, welche die dritte Halbleiterschicht (30) mit der ersten Halbleiterschicht (20) verbindet, wobei die Halbleiterregion (38) die Kompensationsschicht (15) im Leistungshalbleiterbauelement (1) bildet;
Vertiefen des Grabens (35) durch Entfernen von Material der ersten und der zweiten Halbleiterschicht (20, 27), derart dass der vertiefte Graben (35') in die erste Halbleiterschicht (20) eindringt;
Bilden einer Isolierschicht (45), welche die Seitenwand und einen Boden des mindestens einen vertieften Grabens (35') bedeckt, wobei die Isolierschicht (45) die Gate-Isolierschicht (11) im Leistungshalbleiterbauelement (1) bildet; und
Bilden einer Elektrodenschicht (50) in dem mindestens einen vertieften Graben (35'), wobei die Elektrodenschicht (50) von der ersten Halbleiterschicht (20), der zweiten Halbleiterschicht (27), der dritten Halbleiterschicht (30) und der Halbleiterregion (38) des ersten Leitfähigkeitstyps durch die Isolierschicht (45) elektrisch isoliert ist, wobei die Elektrodenschicht (50) die Gate-Elektrode (10) im Leistungshalbleiterbauelement (1) bildet.

**12.** Verfahren zur Herstellung eines Leistungshalbleiterbauelements nach Anspruch 11, wobei das Einbringen der Verunreinigung (38) des ersten Leitfähigkeitstyps in die Seitenwand des mindestens einen Grabens (35) durch Winkel-Ionenimplantation durchgeführt wird.

**13.** Verfahren zur Herstellung eines Leistungshalbleiterbauelements nach Anspruch 11, wobei das Einbringen der Verunreinigung (38) des ersten Leitfähigkeitstyps in die Seitenwand des mindestens einen Grabens (35) durch Plasma-Immersions-Ionenimplantation durchgeführt wird.

**14.** Verfahren zur Herstellung eines Leistungshalbleiterbauelements nach einem der Ansprüche 11 bis 13, wobei eine Halbleitermuldenregion (42) des zweiten Leitfähigkeitstyps unter einem Boden des mindestens einen vertieften Grabens (35') durch Einbringen einer Verunreinigung des zweiten Leitfähigkeitstyps in die erste Halbleiterschicht (20) durch den Boden des mindestens einen vertieften Grabens (35') gebildet wird.

**15.** Verfahren zur Herstellung eines Leistungshalbleiterbauelements nach einem der Ansprüche 11 bis 14, wobei die dritte Halbleiterschicht (30) durch Einbringen einer Verunreinigung des ersten Leitfähigkeitstyps in die zweite Halbleiterschicht (27) gebildet wird.

**Revendications**

**1.** Un dispositif semi-conducteur de puissance (1) comprenant :

une couche de substrat (9) ayant un premier type de conductivité ;
une couche de corps (6) disposée sur la couche de substrat (9) et ayant un deuxième type de conductivité, qui est différent du premier type de conductivité ;
une couche de source (5) disposée sur la couche de corps (6) et ayant le premier type de conductivité, la couche de corps (6) comprenant une région de canal s'étendant de la couche de source (5) à la couche de substrat (9),
une électrode de grille électriquement conductrice (10) pénétrant à travers la couche de corps (6) pour contrôler la conductivité électrique de la région de canal,
une couche d'isolation de grille (11) isolant électriquement l'électrode de grille (10) de la couche de substrat (9), de la couche de corps (6) et de la couche de source (5),
une couche de compensation (15) du premier type de conductivité, qui s'étend directement sur la couche d'isolation de grille (11) entre la couche de source (5) et la couche de substrat (9), directement adjacente à la région de canal, la région de canal étant définie comme une partie de la couche de corps (6) qui est à une distance de moins de 0,1 μm de la couche de compensation (15), dans lequel :

$$L_{ch} > 4\sqrt{\left(\frac{(\varepsilon_{CR} t_{COMP} t_{GI})}{\varepsilon_{GI}}\right)},$$

où $L_{ch}$ est une longueur de canal, $\varepsilon_{CR}$ est une permittivité de la région de canal, $\varepsilon_{GI}$ est une permittivité de la couche d'isolation de grille (11), $t_{COMP}$ est une épaisseur de la couche de compensation (15) dans une direction perpendiculaire à une interface entre la couche d'isolation de grille (11) et la couche de compensation (15), et $t_{GI}$ est une épaisseur de la couche d'isolation de grille (11),
**caractérisé en ce que** l'épaisseur $t_{COMP}$ de la couche de compensation (15) se situe dans une gamme de 1 nm à 10 nm.

**2.** Le dispositif semi-conducteur de puissance selon la revendication 1, dans lequel l'épaisseur $t_{COMP}$ de la couche de compensation (15) se situe dans une gamme de 2 nm à 5 nm.

**3.** Le dispositif semi-conducteur de puissance selon la revendication 1 ou 2, dans lequel la longueur de canal $L_{ch}$ est inférieure à 0,5 μm.

**4.** Le dispositif semi-conducteur de puissance selon la revendication 1 ou 2, dans lequel la longueur de canal $L_{ch}$ est inférieure à 0,3 μm.

**5.** Le dispositif semi-conducteur de puissance selon l'une quelconque des revendications 1 à 4, dans lequel une concentration de dopage dans la couche de compensation (15) est d'au moins $1 \cdot 10^{18}$ cm$^{-3}$.

**6.** Le dispositif semi-conducteur de puissance selon la revendication 5, dans lequel une concentration de dopage dans la couche de compensation (15) est d'au moins $5 \cdot 10^{18}$ cm$^{-3}$.

**7.** Le dispositif semi-conducteur de puissance selon l'une quelconque des revendications 1 à 6, dans lequel une concentration de dopage dans la région de canal est d'au moins $5 \cdot 10^{17}$ cm$^{-3}$.

**8.** Le dispositif semi-conducteur de puissance selon l'une quelconque des revendications 1 à 6, dans lequel une concentration de dopage dans la région de canal est d'au moins $1 \cdot 10^{18}$ cm$^{-3}$ ou au moins $5 \cdot 10^{18}$ cm$^{-3}$.

9. Le dispositif semi-conducteur de puissance selon l'une quelconque des revendications 1 à 8, dans lequel la couche de substrat (9), la couche de corps (6), la couche de compensation (15) et la couche de source (5) sont des couches de carbure de silicium.

10. Le dispositif semi-conducteur de puissance selon l'une quelconque des revendications 1 à 9, comprenant une région de puits (42) du deuxième type de conductivité, la région de puits (42) étant directement adjacente à la couche d'isolation de grille (11) au-dessous d'un bas de l'électrode de grille (10).

11. Un procédé de fabrication d'un dispositif semi-conducteur de puissance (1) selon l'une quelconque des revendications 1 à 10, le procédé comprenant les étapes suivantes :

se procurer une première couche semi-conductrice (20) du premier type de conductivité, la première couche semi-conductrice (20) ayant un premier côté principal (23) et un deuxième côté principal (24) à l'opposé du premier côté principal (23), la première couche semi-conductrice (20) formant la couche de substrat (9) dans le dispositif semi-conducteur de puissance (1) ;
former une deuxième couche semi-conductrice (27) du deuxième type de conductivité sur le premier côté principal (23) de la première couche semi-conductrice (20) pour qu'elle soit en contact direct avec la première couche semi-conductrice (20), la deuxième couche semi-conductrice (27) formant la couche de corps (6) dans le dispositif semi-conducteur de puissance (1) ;
former une troisième couche semi-conductrice (30) du premier type de conductivité, qui est en contact direct avec la deuxième couche semi-conductrice (27) et qui est séparée de la première couche semi-conductrice (20) par la deuxième couche semi-conductrice (27), la troisième couche semi-conductrice (30) formant la couche de source (5) dans le dispositif semi-conducteur de puissance (1) ;
former au moins une tranchée (35) pénétrant à travers la troisième couche semi-conductrice (30) jusqu'à l'intérieur de la deuxième couche semi-conductrice (27) en retirant de la matière de la troisième et la deuxième couche semi-conductrice (30, 27) ;
appliquer une impureté (38) du premier type de conductivité à l'intérieur d'une paroi latérale de l'au moins une tranchée (35) pour former une région semi-conductrice (38) du premier type de conductivité, qui relie la troisième couche semi-conductrice (30) à la première couche semi-conductrice (20), la région semi-conductrice (38) formant la couche de compensation (15) dans le dispositif semi-conducteur de puissance (1) ;
approfondir la tranchée (35) en retirant de la matière de la deuxième et la première couche semi-conductrice (20, 27) de telle sorte que la tranchée approfondie (35') pénètre à l'intérieur de la première couche semi-conductrice (20) ;
former une couche d'isolation (45) recouvrant la paroi latérale et un fond de l'au moins une tranchée approfondie (35'), la couche d'isolation (45) formant la couche d'isolation de grille (11) dans le dispositif semi-conducteur de puissance (1) ; et
former une couche d'électrode (50) dans l'au moins une tranchée approfondie (35'), la couche d'électrode (50) étant électriquement isolée de la première couche semi-conductrice (20), la deuxième couche semi-conductrice (27), la troisième couche semi-conductrice (30) et la région semi-conductrice (38) du premier type de conductivité par la couche d'isolation (45), la couche d'électrode (50) formant l'électrode de grille (10) dans le dispositif semi-conducteur de puissance (1) .

12. Le procédé de fabrication d'un dispositif semi-conducteur de puissance selon la revendication 11, dans lequel l'application de l'impureté (38) du premier type de conductivité à l'intérieur de la paroi latérale de l'au moins une tranchée (35) est effectuée par implantation ionique inclinée.

13. Le procédé de fabrication d'un dispositif semi-conducteur de puissance selon la revendication 11, dans lequel l'application de l'impureté (38) du premier type de conductivité à l'intérieur de la paroi latérale de l'au moins une tranchée (35) est effectuée par implantation ionique par immersion plasma.

14. Le procédé de fabrication d'un dispositif semi-conducteur de puissance selon l'une quelconque des revendications 11 à 13, dans lequel une région de puits semi-conductrice (42) du deuxième type de conductivité est formée au-dessous d'un fond de l'au moins une tranchée approfondie (35') en appliquant une impureté du deuxième type de conductivité dans la première couche semi-conductrice (20) par le fond de l'au moins une tranchée approfondie (35').

15. Le procédé de fabrication d'un dispositif semi-conducteur de puissance selon l'une quelconque des revendications 11 à 14, dans lequel la troisième couche semi-conductrice (30) est formée en appliquant une impureté du premier type de conductivité dans la deuxième couche semi-conductrice (27).

FIG. 1

FIG. 2

FIG. 3A

FIG. 3B

FIG. 3C

FIG. 3D

FIG. 3E

FIG. 3F

FIG. 3G

**EP 3 363 051 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20140159053 A1
- JP 2013219161 A
- US 20140110723 A1
- US 8476697 B1